# EUROPEAN PATENT SPECIFICATION

(11) **EP 3 264 061 B1**
(45) Date of publication and mention of the grant of the patent: **24.04.2019**
(21) Application number: 17161608.9
(22) Date of filing: 17.03.2017
(51) Int. Cl.: G01M 17/08, B61L 15/00, B61L 27/00, G01R 29/08, B60L 3/00, G01R 31/00

(54) **NOISE MONITORING SYSTEM, RAILWAY VEHICLE EQUIPPED THEREWITH, AND NOISE MONITORING METHOD**
GERÄUSCHÜBERWACHUNGSSYSTEM, SCHIENENFAHRZEUG DAMIT UND GERÄUSCHÜBERWACHUNGSVERFAHREN
SYSTÈME DE SURVEILLANCE DE BRUIT, VÉHICULE FERROVIAIRE EN ÉTANT ÉQUIPÉ ET PROCÉDÉ DE SURVEILLANCE DE BRUIT

(30) Priority: 28.06.2016 JP 2016127653
(43) Date of publication of application: 03.01.2018
(73) Proprietor: Hitachi, Ltd., Tokyo 100-8280 (JP)
(72) Inventor: FUKUMASU, Keisuke, Chiyoda-ku, Tokyo 100-8280 (JP); LI, Jia, Chiyoda-ku, Tokyo 100-8280 (JP); FUNATO, Hiroki, Chiyoda-ku, Tokyo 100-8280 (JP); MATSUSHIMA, Kiyoto, Chiyoda-ku, Tokyo 100-8280 (JP); NAKAHARA, Kazushige, Chiyoda-ku, Tokyo 100-8280 (JP)
(74) Representative: Mewburn Ellis LLP

(56) References cited:
- JP-A- 2010 127 798
- US-A1- 2014 062 502
- US-A1- 2016 154 406
- US-B1- 6 321 170
- Falko Rohmert: "Diagnostic System in Rail Vehicles", PRAXIS Profiline - CANopen, 31 January 2002 (2002-01-31), pages 2-3, XP055413205, Retrieved from the Internet: URL:https://www.ifm.com/obj/rail_vehicles. pdf [retrieved on 2017-10-06]
- BEN SLIMEN N ET AL: "On board measurements of the railway's electromagnetic noise with moving train", ELECTROMAGNETIC COMPATIBILITY, 2007. EMC ZURICH 2007. 18TH INTERNATION AL ZURICH SYMPOSIUM ON, IEEE, PI, 1 September 2007 (2007-09-01), pages 365-368, XP031164470, ISBN: 978-3-9523286-1-3
- MIDYA S ET AL: "An overview of electromagnetic compatibility challenges in European Rail Traffic Management System", TRANSPORTATION RESEARCH. PART C, EMERGING TECHNOLOGIES, PERGAMON, NEW YORK, NY, GB, vol. 16, no. 5, 1 October 2008 (2008-10-01), pages 515-534, XP022797498, ISSN: 0968-090X, DOI: 10.1016/J.TRC.2007.11.001 [retrieved on 2008-02-07]

## Description

### TECHNICAL FIELD

The present invention relates to a noise monitoring system, a railway vehicle equipped therewith, and a noise monitoring method.

### BACKGROUND ART

There is JP 6-288873 A (Patent Document 1) as a background art of the present technical field. In this publication, "A failure part, failure content, and the like of a vehicle are rapidly and accurately detected on a vehicle side or a side outside the vehicle. A navigation device includes a navigation control unit 4 to which information such as a current position or a traveling state of a vehicle 2 is input from a first sensor 8 and a second sensor 9 and a failure signal and information necessary for failure diagnosis are input from control units 11 to 13 when a mechanical section of the vehicle 2 has a failure, a display screen 6, and a memory 10, and when a failure signal is input from the control units 11 to 13, the navigation control unit 4 stores information necessary for failure diagnosis of the mechanical section of the vehicle input from the control units 11 to 13 in the memory 10, generates failure-related information such as a failure part or failure content in the mechanism part of the vehicle 2, and causes the information to be displayed on the display screen 6" is stated (see Abstract).

### CITATION LIST

### PATENT DOCUMENTS

Patent Document 1: JP 6-288873 A

Other patent documents relevant to the invention are JP 2010 127798 A and US 6 321 170 B1.

### SUMMARY OF THE INVENTION

### PROBLEMS TO BE SOLVED BY THE INVENTION

Electric railroads are driven by electric power supplied via overhead wirings and rails. There are cases in which various noises such as an electromagnetic noise generated as a result of separation from a pantograph from an overhead wiring and an electromagnetic noise generated when wheels come into contact with or are separated from the rail in addition to an electromagnetic noise generated by a power converter of a substation and an electromagnetic noise generated by a driving inverter of a railway vehicle are superimposed on one another.

Due to on such noises, signal facilities such as sensors, communication devices, or railroad crossing controllers in the railway vehicle may malfunction, and in order to take countermeasures against such noises, there is a demand for a technique of specifying and analyzing a part in which a noise occurs or a propagation path thereof.

In the technique disclosed in Patent Document 1, it is possible to detect the failure content or the failure part of the vehicle, but since a function of monitoring and analyzing a noise which is a cause of a failure or a malfunction is not provided, it is difficult to specify a failure occurrence factor, it is difficult to review countermeasures against noises, and it requires a lot of time and expense to take countermeasures. Further, there is a problem in that installation positions of noise sensors necessary for monitoring occurrence and propagation of such noises in the electric railroad are unclear.

In this regard, it is an object of the present invention to provide a noise monitoring system capable of analyzing a source and a propagation path of noise, a railway vehicle equipped with the noise monitoring system, and a noise monitoring method using the noise monitoring system.

### SOLUTIONS TO PROBLEMS

In order to solve the above problem, for example, configurations set forth in claims are employed. The present invention includes a plurality of means for solving the above problem, but as one of examples thereof, provided is a noise monitoring system, as set out in claim 1.

Further, according to the present invention, provided is a railway vehicle as set out in claim 3.

Further, according to the present invention, provided is a noise monitoring method using a noise monitoring system, as set out in claim 5.

### EFFECTS OF THE INVENTION

According to the present invention, it is possible to provide a railway vehicle equipped with a noise monitoring system capable of analyzing a source of and a propagation path of noise. Further, according to the present invention, it is possible to implement preventive maintenance for noise troubles by monitoring an electromagnetic noise environment of a vehicle. Furthermore, there is an effect in that it is possible to specify a noise source and a propagation path, and it is possible to reduce a time required to take countermeasures when a noise occurs. A problem, a configuration, and an effect which are not mentioned above will be apparent from description of the following embodiments.

### BRIEF DESCRIPTION OF THE DRAWINGS

Fig. 1 is a block diagram illustrating an overall configuration of a railway vehicle and a noise monitoring system according to a first embodiment of the present invention.
Fig. 2 is a block diagram illustrating a configuration of the noise monitoring system according to the first embodiment of the present invention.
Fig. 3 is a block diagram illustrating a configuration of a detecting unit in the noise monitoring system according to the first embodiment of the present invention.
Fig. 4 is a block diagram illustrating a configuration of a processing unit in the noise monitoring system according to the first embodiment of the present invention.
Fig. 5 is a graph illustrating a sensor signal waveform, a vehicle data signal waveform, and an error flag signal waveform indicating storage ranges of sensor data and vehicle data for an error flag in the noise monitoring system according to the first embodiment of the present invention.
Fig. 6 is a flowchart illustrating a flow of a vehicle noise monitoring method in the noise monitoring system according to the first embodiment of the present invention.
Fig. 7 is a partial flowchart illustrating detailed steps of S613 of the flowchart of Fig. 6 in the noise monitoring system according to the first embodiment of the present invention.
Fig. 8 is a front view of a screen displaying a processing result in the noise monitoring system according to the first embodiment of the present invention.
Fig. 9 is a block diagram illustrating an overall configuration of a noise monitoring system according to a second embodiment of the present invention.
Fig. 10 is a block diagram illustrating a configuration of a delay processing unit in the noise monitoring system according to the second embodiment of the present invention.
Fig. 11 is a block diagram illustrating a configuration of a delay processing unit in the noise monitoring system according to the second embodiment of the present invention.
Fig. 12 is a block diagram illustrating a configuration of a processing unit in a noise monitoring system according to a third embodiment of the present invention.
Fig. 13 is a block diagram illustrating an overall configuration of a noise monitoring system according to a fourth embodiment of the present invention.
Fig. 14 is a block diagram illustrating a configuration of a detecting unit in a noise monitoring system according to a fourth embodiment of the present invention.
Fig. 15 is a block diagram illustrating an overall configuration of a noise monitoring system according to a fifth embodiment of the present invention.
Fig. 16 is a block diagram illustrating a configuration of a detecting unit in the noise monitoring system according to the fifth embodiment of the present invention.

### MODE FOR CARRYING OUT THE INVENTION

In the present invention, sensors are arranged at a plurality of positions in a railway vehicle, outputs of the sensors and vehicle data in an in an arbitrary period of time before and after an occurrence timing of a malfunction or a sudden noise are recorded in synchronization with the occurrence timing, and a vehicle noise state is monitored for a long period of time. By post-processing position information of the sensors and noise waveform information, it is possible to specify a source or a propagation path of a noise rapidly, and further, by comparing and analyzing using past noise information, a temporal change is recognized, and preventive maintenance of a noise problem is implemented.

Further, in the present invention, a noise monitoring system is configured with sensors that are arranged at a plurality of positions in a railway vehicle, a temporary storage memory that continuously records outputs of the sensors, a recording unit that stores data and vehicle data in the memory in an arbitrary period of time before and after a malfunction occurrence timing in synchronization with the malfunction occurrence timing, and a processing unit that compares position information of the sensors with noise waveform information, and the noise monitoring system is applied to the railway vehicle.

More specifically, according to the present invention, provided are a noise monitoring system including sensors that are arranged at a plurality of positions in a vehicle and measure electromagnetic noises, a temporary storage memory that continuously records outputs of the sensors, and a control unit that receives a malfunction detection signal of an electronic device mounted on the railway vehicle, wherein data and vehicle data in the memory in an arbitrary period of time before and after a malfunction occurrence timing are stored in a storage recording unit in synchronization with the malfunction occurrence timing, and noise distribution information is held, a railway vehicle equipped with the noise monitoring system, and a noise monitoring method using the noise monitoring system.

Hereinafter, exemplary embodiments of the present invention will be described in detail with reference to the appended drawings. In all the drawings for describing the embodiments, the same parts are denoted by the same reference numerals in principle, and repeated description thereof is omitted.

### [First embodiment]

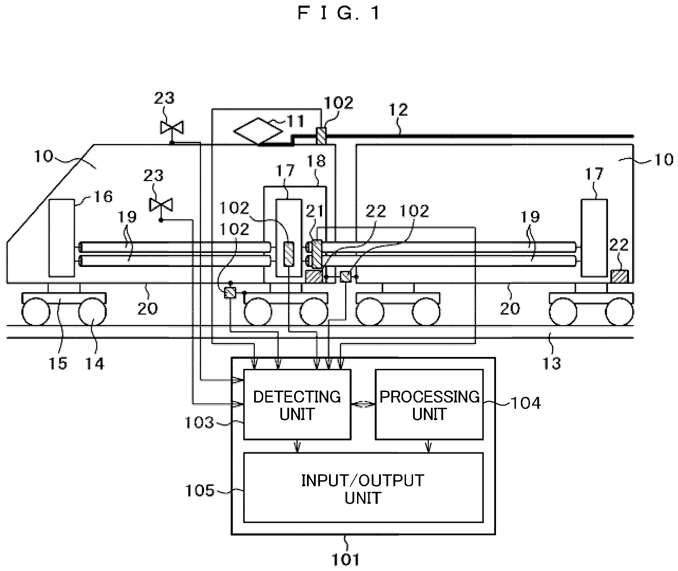

A noise monitoring system according to a first embodiment of the present invention will be described below with reference to Figs. 1 to 6. The present embodiment will be described in connection with an example in which a noise monitoring system is mounted on a railway vehicle, but a mounting specification of the noise monitoring system of the present invention is not limited to the present embodiment.

Fig. 1 is a diagram illustrating the entire railway vehicle equipped with the noise monitoring system according to the present embodiment. A railway vehicle 10 (in Fig. 1, a first vehicle and a second vehicle are different, but they are substantially the same as each other as a target of the present invention, and thus they are indicated by 10) is supplied with electric power from an overhead wiring (not illustrated) via a pantograph 11 and obtains electric power of a high voltage line 12 of the railway vehicle. A driving device (not illustrated) such as an inverter is operated using this electric power. Reference numeral 13 indicates a rail, reference numeral 14 indicates a wheel, and reference numeral 15 indicates a bogie.

Further, the railway vehicle 10 is equipped with a vehicle system control device 16 for each vehicle, and communication between electronic devices (not illustrated) of respective vehicles is performed via a communication device 17. The communication device 17 of each vehicle is mounted in a device installation space called a cubicle 18. A shielded cable with high noise resistance is commonly used as the communication wiring 19 between the communication devices 17.

Fig. 1 illustrates a noise monitoring system 101 together with the railway vehicle 10 and the devices in the vehicle. The noise monitoring system 101 includes a noise detecting unit 103, a processing unit 104, an input/output unit 105, and the like, which will be described in detail later. In order to monitor a noise source and a propagation inside and outside the railway vehicle 10 using this noise monitoring system 101, mounting positions of an on-board sensor 112 and the noise monitoring system 101 are important. Noise occurrence factors in the railway vehicle 10 are roughly classified into a noise caused when an overhead wiring voltage is turned on or off and a noise caused by the device in the vehicle such as the inverter.

On the other hand, as a matter interfered by an electromagnetic noise, there is the communication wiring 19 for the communication device 17 in the vehicle. The electromagnetic noise has a high voltage of kV or more in the occurrence source, but the communication wiring 19 that is interfered may have a very low voltage of several volts or less. Therefore, in the noise monitoring system 101, in order to measure an amount of noise of both a noise source and an interfered part, it is necessary to install the system near a noise interference amount measurement position so that the noise monitoring system 101 is not affected by noise. In other words, it is desirable that the noise monitoring system 101 be installed inside the cubicle 18 of the railway vehicle 10, and the on-board sensor 112 that detects the noise is connected to the high voltage line 12 or an inverter wiring (not illustrated) which is likely to be the noise source. When the noise-interfered part is the communication wiring 19 connecting the communication devices 17, it is possible to detect a common mode noise component by measuring and monitoring an induced voltage between a shield 21 at the end of the communication wiring 19 and a communication device ground (GND). Further, when a potential difference between the bogie 15 and the vehicle body 20 of the railway vehicle 10 is measured and monitored through a sensor, it is possible to detect a potential variation of the vehicle body 20. Thus, it is possible to determine whether or not a ground characteristic of the vehicle body 20 deteriorates.

Further, when a potential difference between the railway vehicles 10 is measured and monitored through a resistor 22 disposed in a portion electrically connecting the railway vehicles 10, it is possible to determine whether or not a difference in a ground characteristic of each railway vehicle 10 is large. Further, when an electromagnetic field outside the vehicle is measured and monitored through an antenna 23 attached to the outside of the vehicle body 20, an effect in that it is possible to determine whether or not there is an unnecessary electromagnetic wave reduction inside or outside the vehicle can be expected.

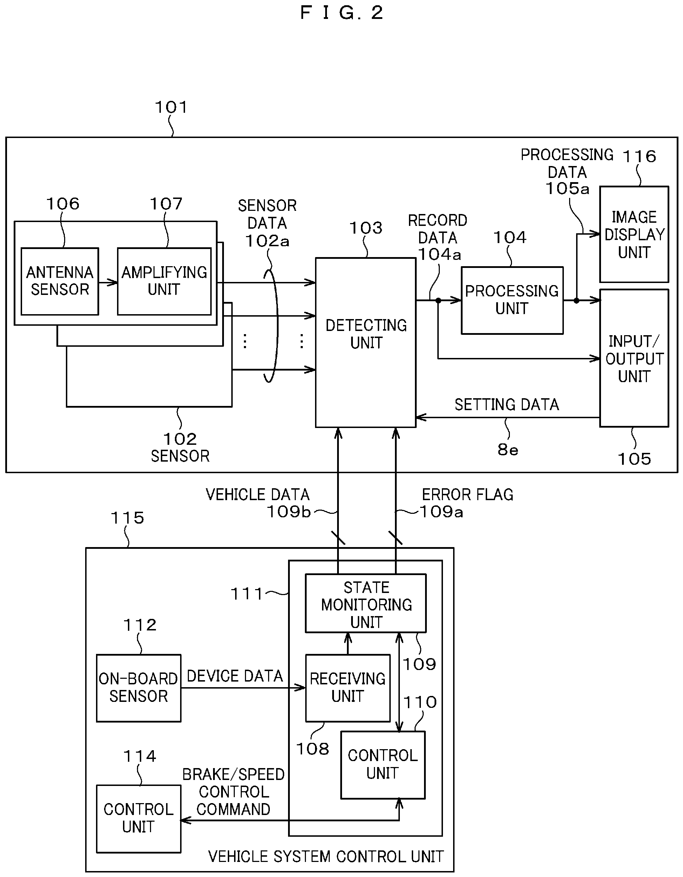

Fig. 2 is a diagram illustrating a configuration of a noise monitoring system according to the present embodiment. In Fig. 2, noise monitoring targets in a vehicle body 115 include a control unit 114 such as an inverter, the on-board sensor 112 such as an ATC/railroad crossing controller which is a sensor of detecting an operation state of a device, and a vehicle system control unit 111 that monitors control or state of each on-board device or vehicle operation information.

The vehicle system control unit 111 includes a control unit 110 that provides a control command (such as brake/speed control) of the control unit 114, a receiving unit 108 that receives device data collected from the on-board sensor 112, and a state monitoring unit 109 that checks whether or not there is a malfunction in the device by monitoring a state of each device in the vehicle and comparing a monitored state with the control command.

The on-board sensor 112 includes, for example, sensors installed at positions which are likely to be a noise source such as a sensor (not illustrated) attached to the antenna 23, a sensor installed in an inverter wiring (not illustrated), and a sensor attached to a part that measures an induced voltage between the shield 21 at the end of the communication wiring 19 and a communication device ground (not illustrated).

When a malfunction occurs in the vehicle device, an error flag 109a indicating the occurrence of malfunction is output from the state monitoring unit 109 to the noise monitoring system 101 side. The noise monitoring system 101 performs measurement and recording of an electromagnetic noise and analysis of a source and a propagation path of an electromagnetic noise in synchronization with a signal of the inputted error flag 109a.

The noise monitoring system 101 includes a sensor 102 that measures an electromagnetic noise, a detecting unit 103 that records sensor data 102a before and after a malfunction occurrence time, a processing unit 104 that analyzes a source and a propagation path of an of electromagnetic noise on the basis of record data 104a of the detecting unit 103, an image display unit 116 that displays an analysis result, and an input/output unit 105 that performs display of processing data 105a, reading of record data 104a, and input of setting data 8e from the outside.

The processing unit 104 detects the error flag 109a indicating the occurrence of malfunction while constantly monitoring the sensor data 102a output from the sensor 102, the error flag 109a output from the state monitoring unit 109, and vehicle data 109b (an operation mode, a train position, a speed, and the like) which is device data indicating operating environment information of a monitoring target device. Further, the processing unit 104 records sensor data 102a in a certain range of time before and after the occurrence time together with the vehicle data 109b and the error flag 109a in synchronization with the malfunction occurrence time at which the error flag 109a is detected.

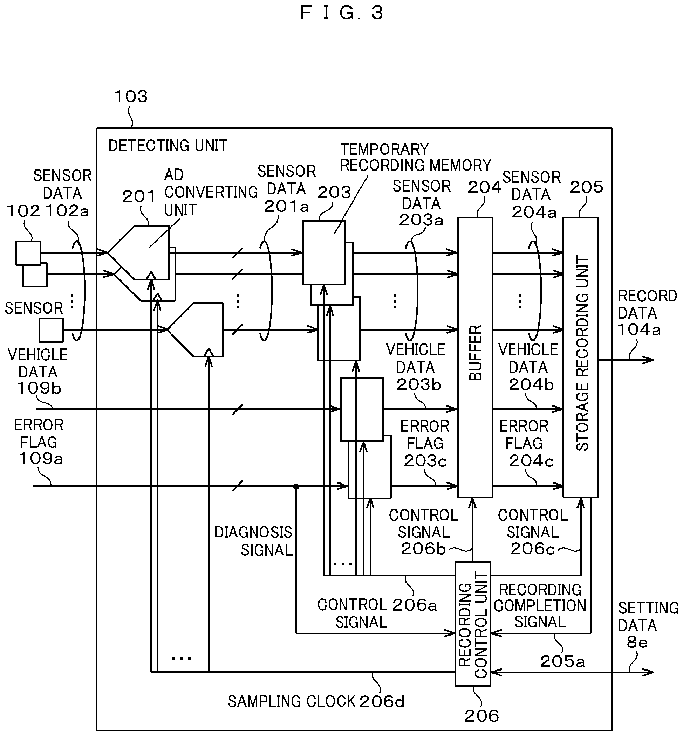

Fig. 3 is a diagram illustrating a configuration of the detecting unit 103. The detecting unit 103 includes an AD converting unit 201, a temporary recording memory 203, a buffer 204, a storage recording unit 205, and a recording control unit 206.

The AD converting unit 201 performs AD conversion on the sensor data 102a input from the sensor 102. The temporary recording memory 203 temporarily stores the converted sensor data 201a, the vehicle data 109b input from the state monitoring unit 109 of the vehicle system control unit 111, and the error flag 109a input from the state monitoring unit 109 of the vehicle system control unit 111. The buffer 204 and the storage recording unit 205 store sensor data 203a, vehicle data 203b, and an error flag 203c in a time range designated by setting data 8e. The recording control unit 206 performs control such that the sensor data 203a, the vehicle data 203b, and the error flag 203c in the time range designated by the setting data 8e are written in the buffer 204 and the storage recording unit 205 using the error flag 109a indicating the occurrence of malfunction of the vehicle device as a trigger.

An operation of the detecting unit 103 will be described below on the basis of the configuration illustrated in Fig. 3. The sensor data 102a inputted from the sensor 102 that measures the electromagnetic noise undergoes AD conversion by the AD converting unit 201 in accordance with a sampling clock 206d output from the recording control unit 206. The sensor data 201a that has undergone the AD conversion by the AD converting unit 201 is loop-stored in the temporary recording memory 203 together with the vehicle data 109b and the error flag 109a output from the state monitoring unit 109.

The recording control unit 206 performs control such that a signal in a time range specified by the setting data 8e of a recording time input from the input/output unit 105 among the sensor data 203a, the vehicle data 203b, and the error flag 203c stored in the temporary recording memory 203 is written in the storage recording unit 205 via the buffer 204 using the error flag 109a indicating the occurrence of malfunction as a trigger.

Although not illustrated, control signals 206a, 206b, and 206c output from the recording control unit 206 are memory address signals or write control signals, and the memory address signals are generated by an address counter in the recording control unit 206.

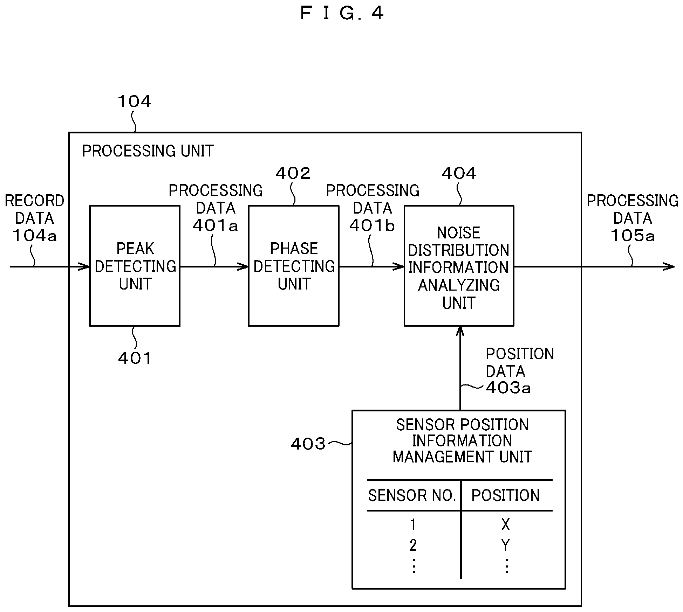

Fig. 4 is a diagram illustrating a configuration of the processing unit 104. The processing unit 104 includes a peak detecting unit 401, a phase detecting unit 402, a sensor position information management unit 403, and a noise distribution information analyzing unit 404. The peak detecting unit 401 extracts a peak (a maximum value of an amplitude) and a time of the record data 104a at the time of the occurrence of malfunction which is output from the storage recording unit 205 of the detecting unit 103. The phase detecting unit 402 compares a time difference of processing data 401a output from the peak detecting unit 401.

The sensor position information management unit 403 provides a position information of the sensor to the noise distribution information analyzing unit 404, and the noise distribution information analyzing unit 404 obtains a noise distribution using the processing data 401a output from the phase detecting unit 402 and position data 403a of the sensor output from the sensor position information management unit 403, and outputs the processing data 105a.

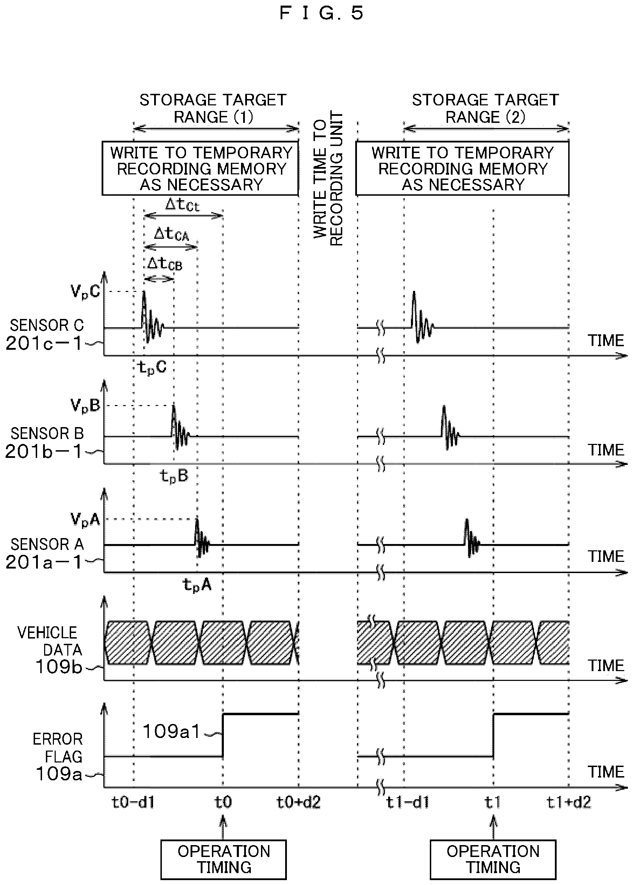

Fig. 5 is a diagram illustrating storage ranges of the sensor data 201a and the vehicle data 109b for the error flag 109a in the system according to the embodiment of the present invention. In Fig. 5, sensor data 201a-1 to 201a-3, the vehicle data 109b, and the error flag 109a of a plurality of sensors A, B, and C which have undergone the AD conversion are illustrated on the same time axis.

Fig. 5 illustrates an example in which a waveform of noise is measured using the sensor data 201a-1 to 201a-3 of the three sensors A, B, and C. The sensor data 201a-1 to 201a-3 (these pieces of data are collectively referred to as "sensor data 201a" in Fig. 3), the vehicle data 109b, and the error flag 109a are constantly written and stored in the temporary recording memory 203 for a certain period of time.

When the error flag 109a is output from the state monitoring unit 109 and detected by the recording control unit 206, the sensor data 203a (corresponding to the sensor data 201a that collectively indicates the sensor data 202a-1 to 201a-3), the vehicle data 203b, and the error flag 203c start to be written from the temporary recording memory 203 to the buffer 204 and then written in the storage recording unit 205 via the buffer 204 using a rising edge 109a1 of the error flag 109a as a trigger (an operation timing).

A time range before and after the occurrence of malfunction may be set as the storage ranges of the sensor data 201a, the vehicle data 202b, and the error flag 202c through the setting data 8e which is a set value of the recording control unit 206.

In the example of Fig. 5, t0 and t1 indicate operation timings corresponding to the rising edge 109a1 of the error flag 109a, and d1 and d2 indicate a start time and an end time of the storage range. Here, d1 and d2 are determined in accordance with the setting data 8e. In Fig. 5, peak values of the sensor data 202a-1 to 201a-3 are indicated by VpA, VpB, and VpC, and peak timing are indicated by tpA, tpB, and tpC. ΔtCA, ΔtCB, and ΔtCt indicate a time difference between a peak timing of the sensor C and a peak timing of the sensor A, a time difference between a peak timing of the sensor C and a peak timing of the sensor B, and a time difference between a peak timing of the sensor C and the operation timing.

Next, an operation of the processing unit 104 will be described with reference to Figs. 4 and 5. For the record data 104a of the noise waveform input to the processing unit 104, first, the peak values (VpA, VpB, and VpC in Fig. 5) and peak timings (TpA, tpB, and tpC in Fig. 5) are extracted from noise waveform data of the respective sensors through the peak detecting unit 401.

Then, the phase detecting unit 402 detects the time differences between the peak timings of the noise waveform of the respective sensors. Further, the detected peak values and the time differences are input to the noise distribution information analyzing unit 404, and a correlation of the peak values, the time differences, and the positions of the respective sensors are analyzed using a sensor position matrix provided from the sensor position information management unit 403. The propagation path from the noise source and the noise source to a malfunction occurrence position are analyzed on the basis of the correlation map.

The present processing unit 104 can perform processing in the frequency domain by adding an FFT transform unit in addition to processing in the time domain. For example, it is possible to first perform FFT transform on the record data 104a of the noise waveform input to the processing unit 104 and then detect a frequency component having a maximum strength through the peak detecting unit 401.

An operation overview of the system according to the present embodiment will be described below with reference to Figs. 1 to 5. In Fig. 2, first electromagnetic noises inside and outside the railway vehicle are constantly measured using the sensors 102 arranged at a plurality of positions of the vehicle body 115, and measured waveform data is input to the detecting unit 103 as the sensor data 102a.

Further, synchronous communication with the vehicle system control unit 111 mounted on the railway vehicle 10 is performed, and information related to an operating environment of the vehicle (an operation mode, a train position, a speed, and the like) and an error signal indicating the presence or absence of the occurrence of malfunction are input from the state monitoring unit 109 to the detecting unit 103 as the vehicle data 109b and the error flag 109a together with the sensor data 102a.

The detecting unit 103 performs the AD conversion on the input sensor data 102a and then writes the vehicle data 109b and the error flag 109a in the temporary recording memory 203 constantly. The temporary recording memory 203 stores data which is sequentially written for a certain period of time and then sequentially erases them. Further, the sensor data 203a, the vehicle data 203b, and the error flag 203c stored in the temporary recording memory are written into the storage recording unit 205 via the buffer 204 using the rising edge of the error flag 109a as a trigger. The storage range is determined in accordance with the setting data 8e. Since the storage recording unit 205 stores only data before and after the rising edge of the error flag 109a among a large amount of data which is constantly written in the temporary recording memory 203, the amount of write data per unit time can be reduced, and data of a relatively long time can be stored and saved.

Further, the processing unit 104 compares the peaks of the electromagnetic noises and the time differences among a plurality of sensors among the record data, analyzes the source and the propagation path of the electromagnetic noise, outputs the analysis result to the outside through the input/output unit, and causes the analysis result to be displayed on the image display unit 116.

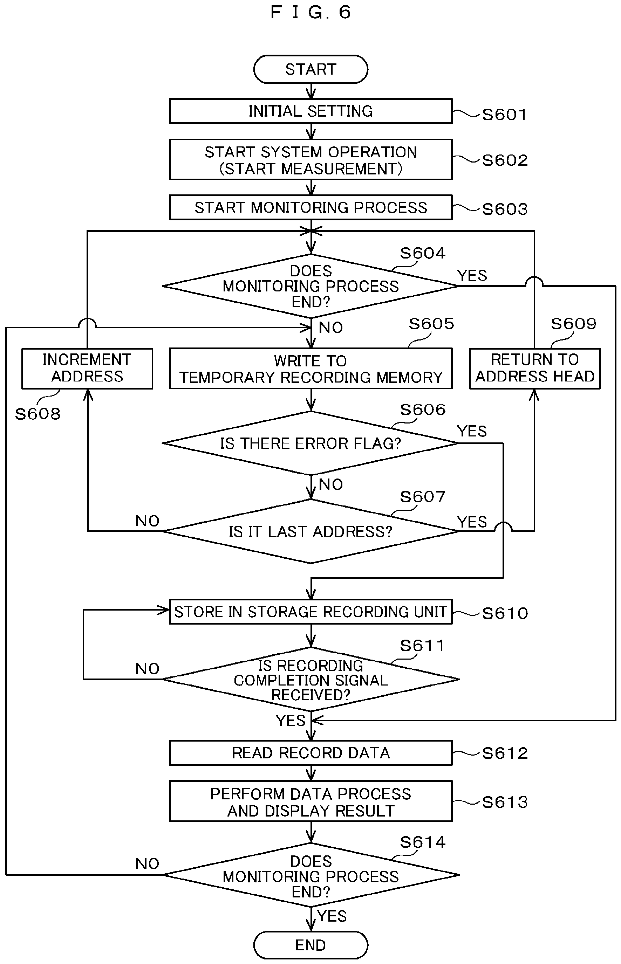

Fig. 6 is a flowchart illustrating the flow of a diagnosis process according to the embodiment of the present invention. First, in step S601, an initial setting of the setting data 8e illustrated in Fig. 3 or the like is performed. Then, in step S602, the operation of the system starts, and noise measurement by the sensor 102 starts. Then, in step S603, the diagnosis process of the detecting unit 103 or the like starts, communication with the vehicle system control unit 111 is performed, and the vehicle data 109b and the error flag 109a starts to be collected from the state monitoring unit 109.

Then, it is checked whether to the monitoring process ends (S604). When the monitoring process is checked to be continued (in the case of NO), the sensor data 201a converted by the AD converting unit 201 and the vehicle data 109b and the error flag 109a collected by the state monitoring unit 109 are written in the temporary recording memory 203 (data storage) (S605).

At this time, the recording control unit 206 monitors the error flag 109a (S606), checks whether or not an address of the temporary recording memory 203 is the last address (S607) when the error flag 109a is not detected (in the case of NO), and increments the address counter (S608) when it is not the last address (in the case of NO), and then the process returns to S604. On the other hand, when it is the last address (YES in S607), the address of the temporary recording memory 203 returns to the head (S609), and the process returns to S604. Steps S605 to S609 indicate a normal operation state in which no abnormality is detected.

On the other hand, when the error flag 109a is detected in S606 (in the case of YES) (when the error flag 109a is detected by the recording control unit 206), an error is determined to have occurred, the loop of the flow from S605 to S609 at the normal time is passed through, and the process proceeds to step S610.

In step S610, the sensor data 203a, the vehicle data 203b, and the error flag 203c stored in the temporary recording memory 203 are written in the storage recording unit 205 via the buffer 204 in accordance with the control signals 206a, 206b, and 206c of the recording control unit 206. Then, it is determined whether or not a recording completion signal is received from the storage recording unit 205 (S611), and when the recording completion signal is not received (in the case of NO), the process returns to step S610, and the recording is continued.

When the recording completion signal is received (YES in S611), transfer of the record data 104a (reading of the record data) written in the storage recording unit 205 to the processing unit 104 is performed (S612), data processing is performed in the processing unit 104 to analyze the source and the propagation path of the noise, the analysis result is output to the outside through the input/output unit, and the analysis result is displayed through the image display unit 116 (S613).

Then, it is checked whether or not the monitoring process ends (S614), and when the monitoring process is continued (in the case of NO), the process returns to S605, and the monitoring process is continued. On the other hand, when it is determined in S614 that the monitoring process is not continued (in the case of YES), the entire process ends.

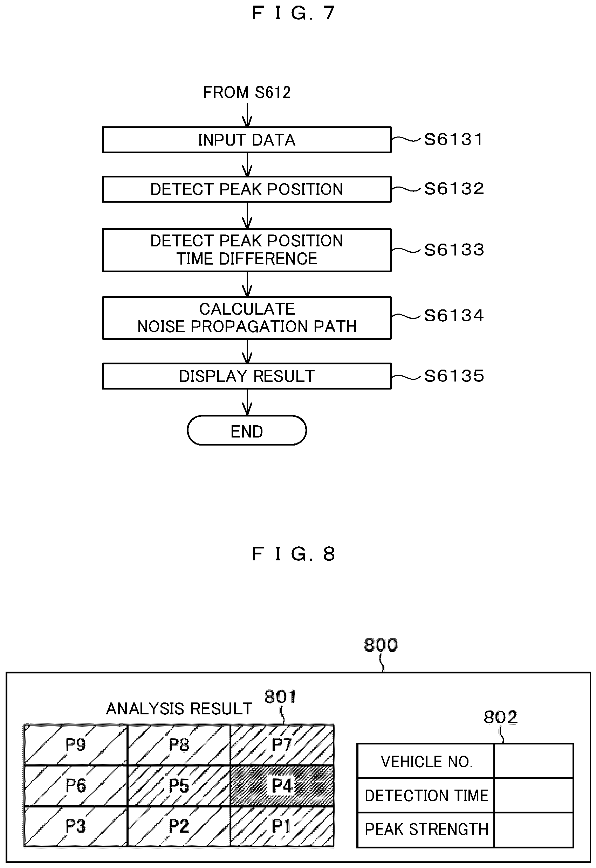

Detailed steps of the process of analyzing the source and the propagation path of the noise in S613 will be described with reference to Fig. 7.

The error flag 203c, the vehicle data 204b, and the sensor data 204a stored in the storage recording unit 205 in S610 since it is determined in S606 that there is an error flag (YES) are transferred to the processing unit 104 as the record data 104a (S6131). In the processing unit 104, first, the peak detecting unit 401 detects the peak position (timing) of each sensor data (S6132). Then, the phase detecting unit 402 obtains the time difference of the peak position between the sensor data at which the peak position is detected (S6133). Then, the propagation path of the electromagnetic noise detected by a certain sensor 102 (a path in which the electromagnetic noise detected by a certain sensor 102 is propagated to another sensor) is obtained using the peak position and the time difference of each sensor data and information on the position at which each sensor 102 is arranged in the railway vehicle 10 (the sensor position information: the position data 403a) (S6134), the obtained propagation path is superimposed on arrangement information of each sensor 102 in the railway vehicle 10, and a result is displayed on the image display unit 116 (S6145).

An example of the analysis result displayed on the image display unit 116 is illustrated in Fig. 8. The image display unit 116 causes the analysis result to be displayed on a screen 800. A display field 801 according to a noise strength of sensors P 1 to P 9 installed in the vehicle body 115 and information 802 such as a vehicle number identifying a vehicle to be inspected, a time at which a noise is detected, and a peak value of the detected noise re displayed on the screen 800, and the propagation state of the noise is visualized and displayed so that the source of the noise can be determined. In the example illustrated in Fig. 8, a position of the sensor P 4 having the highest hatching density is closest to the noise source, and the noise generated therein is propagated to the positions of the sensors P1, P5, and P7, then propagated to the sensors P2, P6, and P8, and further propagated to the sensors P3 and P9.

In the example illustrated in Fig. 8, a display example is indicated by a block for each sensor in the display field 801 of the analysis result, but it may be displayed to be superimposed on a diagram in which the devices are arranged in the vehicle body of the railway vehicle. Accordingly, it is possible to provide the noise monitoring system capable of analyzing the source or the propagation path of the noise.

According to the present embodiment, it is possible to record the noise waveform and the operation information at arbitrary time in synchronization with the vehicle failure signal or a sudden noise occurrence timing, and thus it is possible to specify the source or the propagation path of the noise rapidly and accurately on the basis of the recorded information.

Further, according to the present embodiment, the malfunction can be prevented in advance by specifying the source or the propagation path of the noise in advance and taking countermeasures.

Further, according to the present embodiment, since it is possible to specify the source or the propagation path of the noise rapidly and accurately, it is possible to reduce the time required to take countermeasure when a noise occurs.

### [Second embodiment]

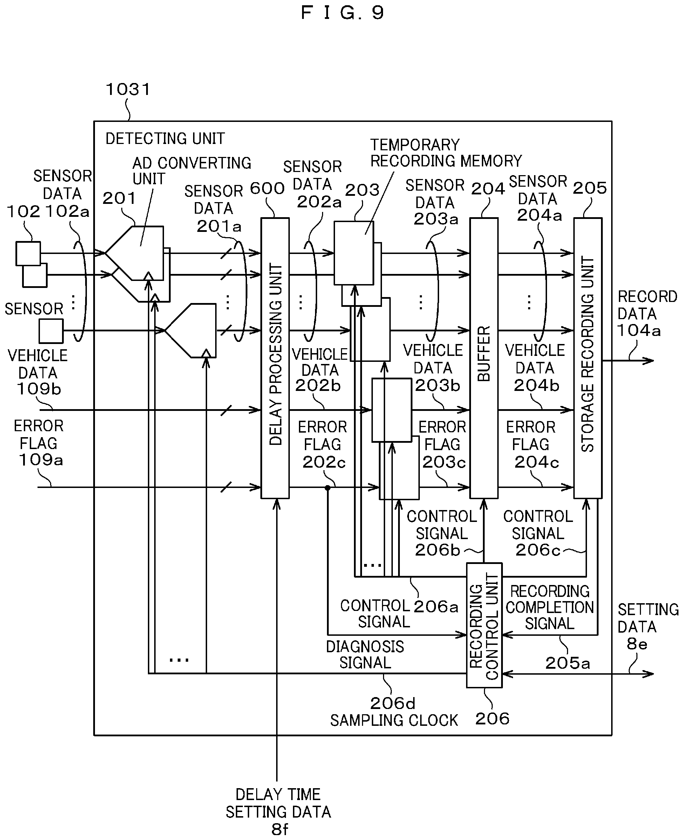

The noise monitoring system according to a second embodiment of the present invention will be described below with reference to Figs. 9 to 11. The present embodiment will be described in connection with an example in which a problem of the degradation of the noise detection accuracy caused by a difference in a sensor wiring length is considered.

Fig. 9 is a diagram illustrating a configuration of the detecting unit 1031 in the noise monitoring system according to the present embodiment. The noise monitoring system according to the present embodiment is a system that has a variation configuration of the detecting unit 103 on the basis of the configuration of Fig. 2 described in the first embodiment. The detecting unit 1031 according to the present embodiment differs from the detecting unit 103 of the first embodiment in that a delay processing unit 600 is added.

In the configuration of the detecting unit 1031 according to the present embodiment illustrated in Fig. 9, the sensor data 201a, the vehicle data 109b, and the error flag 109a which are input to the detecting unit 1031 and undergo the AD conversion by the AD converting unit 201 are first input to the delay processing unit 600. The delay processing unit 600 adjusts a timing at which the sensor data 201a, the vehicle data 109b, and the error flag 109a are input to the temporary recording memory 203 in accordance with delay time data 8f which is set in advance.

For example, when there is a large difference in a wiring delay time due to a difference between a wiring length from the sensor 102 to the detecting unit 1031 and a wiring length from the state monitoring unit 109 to the detecting unit 1031, it is possible to correct the time difference of each data through the delay processing unit 600. Thus, the simultaneity of the error flag 109a output from the state monitoring unit 109 and the sensor data 201a based on the signal output from the sensor 102 is guaranteed. Thereafter, the detecting unit 1031 performs an operation of loop-storing the sensor data 201a that has undergone the AD conversion at the normal time and the vehicle data 109b and the error flag 109a from the state monitoring unit between which the simultaneity is guaranteed in the temporary recording memory 203.

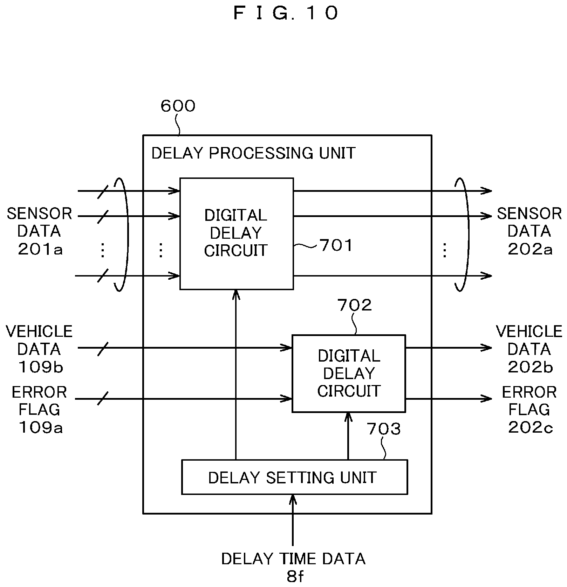

Fig. 10 is a diagram illustrating a configuration of the delay processing unit 600 in the noise monitoring system according to the embodiment of the present invention. The delay processing unit 600 is configured with a digital delay circuit 701 that delays the input sensor data 201a, a digital delay circuit 702 that delays the vehicle data 109b and the error flag 109a, and a delay setting unit 703 that sets delay time data of the digital delay circuit 701 and the digital delay circuit 702.

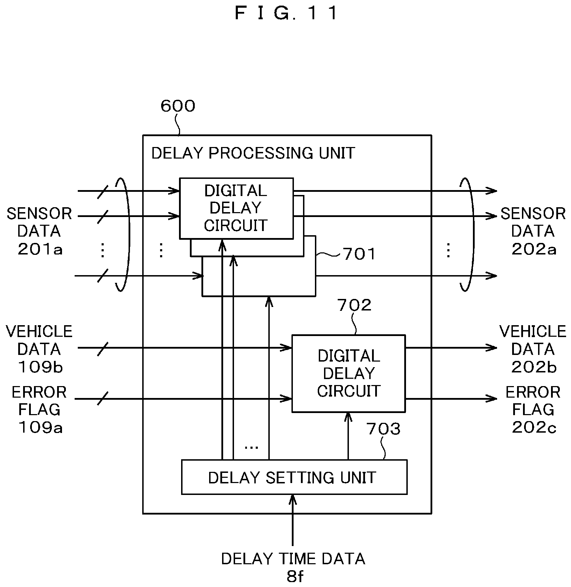

The delay setting unit 703 sets the delay time data in accordance with the delay time data 8f which is set in advance. Here, the delay time data 8f is a delay time obtained by executing the noise monitoring system of the present embodiment under the condition in which a known noise source is disposed and is input from the input/output unit 105, and the delay processing unit 600 illustrated in Fig. 10 is applied when sensors 102 having wirings of an equal length are used, but when wirings of different lengths are used from the sensors 102 arranged in respective sections of the vehicle to the detecting unit 1031, a configuration having a plurality of digital delay circuits 701 each of which is capable of setting a different wiring delay time for each sensor 102 is provided as illustrated in Fig. 11.

Accordingly, according to the present embodiment, it is possible to provide the noise monitoring system capable of analyzing the source or the propagation path of the noise. Further, when the sensor wiring lengths are different, it is possible to correct the wiring delay and prevent the degradation of the noise detection accuracy caused by the wiring delay.

### [Third embodiment]

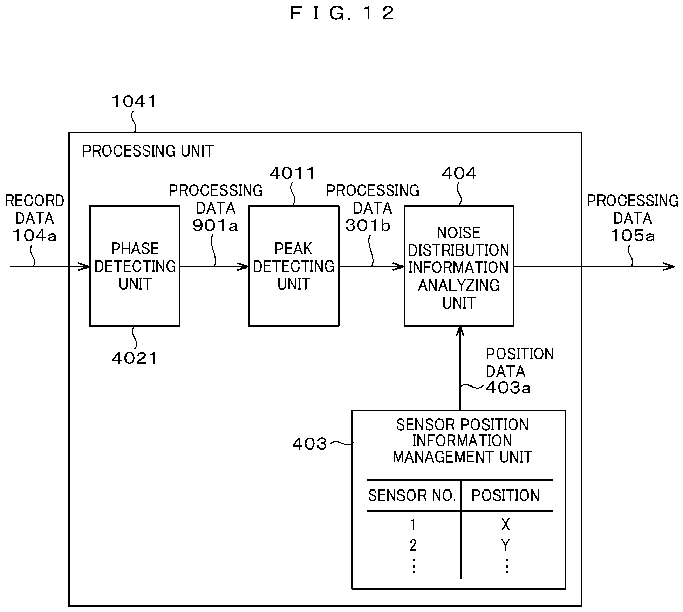

A noise monitoring system equipped with a processing unit 1041 according to a third embodiment of the present invention will be described with reference to Fig. 12. The present embodiment will be described in connection with an example in which it is possible to freely select an order or a type of processing process. The noise monitoring system according to the present embodiment has another variation of the processing unit 104 on the basis of the configuration of Figs. 1 and 2 described in the first embodiment.

Fig. 12 is a diagram illustrating a configuration of the processing unit 1041 in the noise monitoring system according to the present embodiment. The processing unit 1041 includes a phase detecting unit 4021 that compares time differences of the record data 104a at the time of the occurrence of malfunction output from the storage recording unit 205, a peak detecting unit 4011 that compares amplitudes of the processing data 901a obtained by comparing the time differences, a noise distribution information analyzing unit 4041, and a sensor position information management unit 403 that provides sensor position information of the sensor to the noise distribution information analyzing unit 404.

This configuration differs from that of the first embodiment lies in that an order of the peak detecting unit 4011 and the phase detecting unit 4021 is opposite. In order to specify the source and the propagation path of the noise, the peak detecting unit 4011 and the phase detecting unit 4021 that compare the noise strength and the occurrence time are necessary, but a comparison order is not consequential. In addition to the first and third embodiments, the peak detecting unit and the phase detecting unit may be included in one block.

Accordingly, it is possible to provide the noise monitoring system capable of analyzing the source and the propagation path of the noise. When the record data 104a is processed through the processing unit 104, the processing order of the peak detection, the phase detection, and the noise distribution information analysis is not limited, and all of them can be freely selected by the users. Further, it is possible to reduce the number of parts of the processing unit and an occupied area thereof by storing the three processes in one chip.

### [Fourth embodiment]

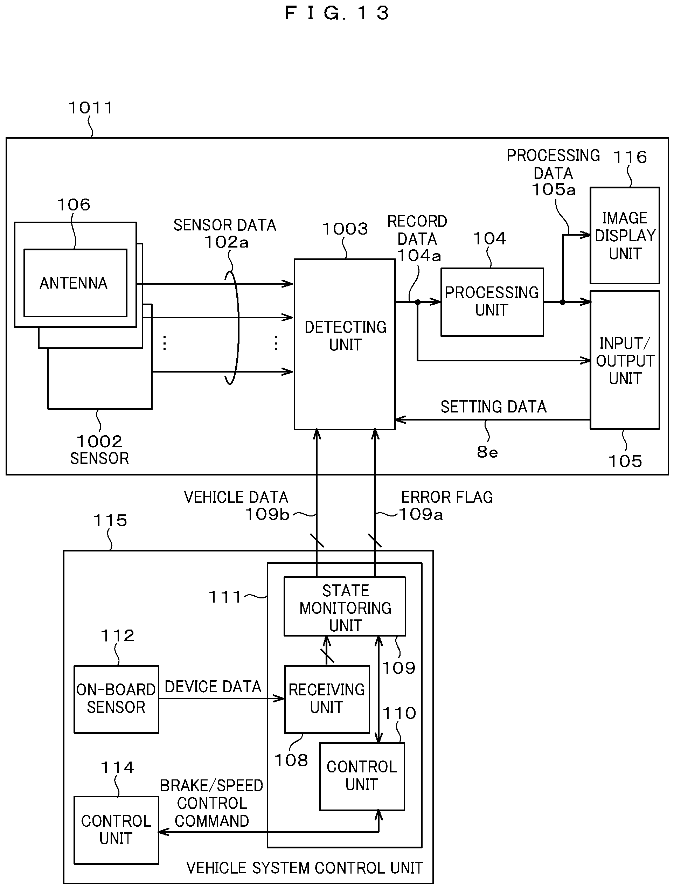

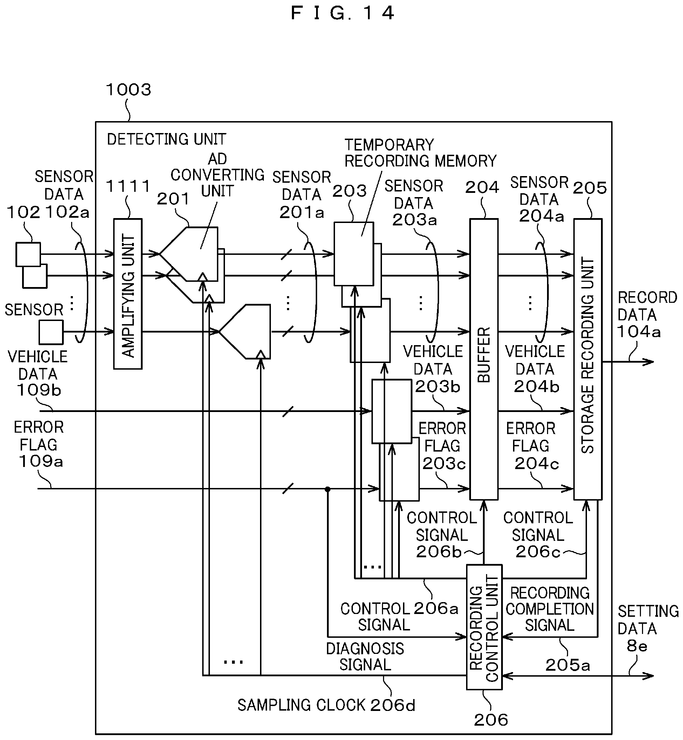

Hereinafter, a noise monitoring system according to a fourth embodiment of the present invention will be described with reference to Figs. 13 and 14. The present embodiment will be described in connection with an example in which the size reduction of the noise monitoring system is implemented. The system according to the present embodiment is a system that has a variation configuration of the sensor 102and the detecting unit 103 on the basis of the configuration of Figs. 1 and 2 described in the first embodiment.

Fig. 13 is a diagram illustrating an overall configuration of a noise monitoring system 1011 according to the present embodiment. As illustrated in Fig. 11, a sensor 1002 has only an antenna 106.

Fig. 14 is a diagram illustrating a configuration of a detecting unit 1003 in the noise monitoring system 1011 according to the present embodiment. Instead of an amplifying unit 107 disposed in each sensor 102 in the first embodiment, an amplifying unit 1111 is disposed on the detecting unit 1003 side in the present embodiment. Here, the sensor data 102a input to the detecting unit 1003 is amplified by the amplifying unit 1111 and then undergoes the AD conversion, similarly to the first embodiment.

Accordingly, it is possible to provide the noise monitoring system capable of analyzing the source and the propagation path of the noise. Further, since the sensor includes only the antenna, the size reduction of the sensor can be implemented. Further, since one amplifying unit is disposed instead of a plurality of amplifying units, a chip volume can be reduced as well.

### [Fifth embodiment]

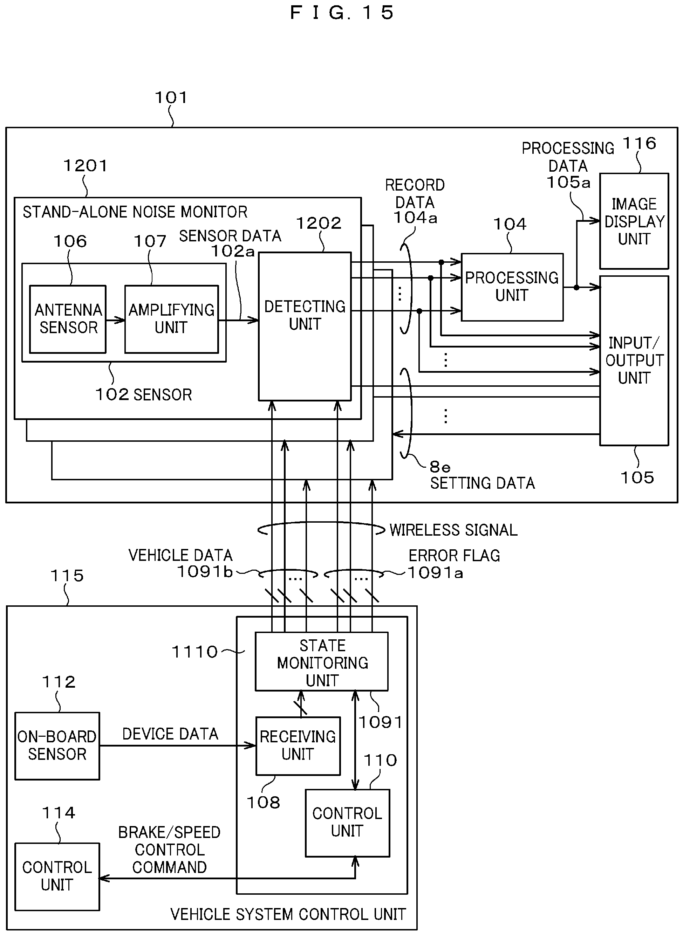

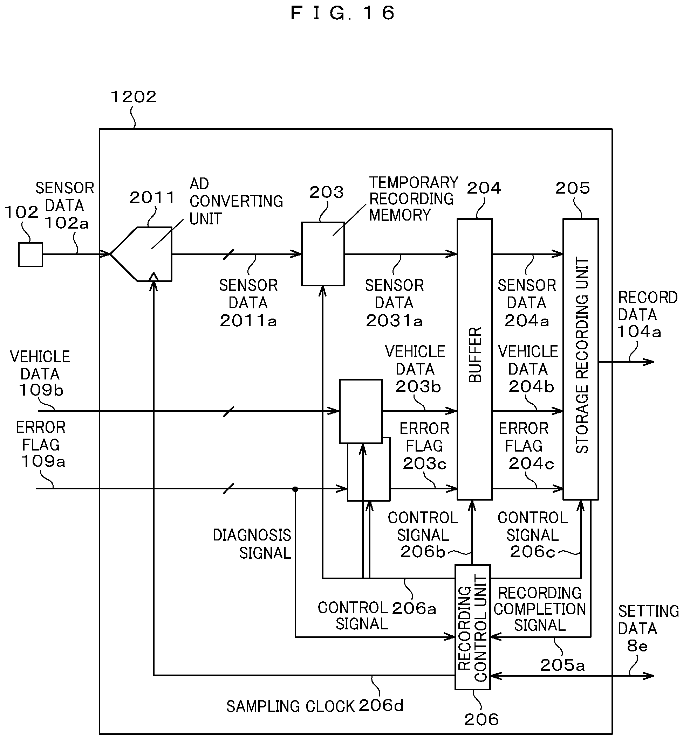

A noise monitoring system according to a fifth embodiment of the present invention will be described with reference to Figs. 15 and 16. The present embodiment will be described in connection with an example in which an increase in a wiring cost or a variation in a wiring delay is reduced in view of an increase in the number of wirings in the system. The system according to the present embodiment is a system which is on the basis of the configuration of Figs. 1 and 2 described in the first embodiment and acquires an error flag 1091a and vehicle data 109b from a state monitoring unit 1091 of a vehicle system control unit 1110 in a wireless manner.

Fig. 15 is a diagram illustrating an overall configuration of a noise monitoring system according to the present embodiment. In this configuration, a stand-alone noise monitor 1201 including a single sensor 102 for noise measurement and a detecting unit 1202 which operates in conjunction with a vehicle system control unit 1110 in a wireless manner.

Fig. 16 is a diagram illustrating the detecting unit 1202 in the noise monitoring system according to the present embodiment. A difference with the detecting unit 103 described in the first embodiment lies in that a single AD converting unit and ta temporary recording memory according to sensor data input from a single sensor are disposed.

In the stand-alone noise monitor 1201, the error flag 1091a and the vehicle data 1091b input from the state monitoring unit 1091 of the vehicle system control unit 111 acquired in a wireless manner are stored in a temporary recording memory 2031 together with the sensor data 102a obtained by performing the AD conversion on the sensor data 102a input from the sensor 102 through the AD converting unit 2011, and sensor data 2031a, vehicle data 203b, and error flag 203c are written from data stored in the temporary recording memory 2031 to the storage recording unit 205 via the buffer 204 via the buffer 204 using the rising edge of the error flag 1091a as a trigger.

A storage range is determined in accordance with the setting data 8e. Thereafter, similarly to the first embodiment, the source and the propagation path of the electromagnetic noise are analyzed by comparing the amplitudes and the time differences of the electromagnetic noise of a plurality of sensors 102 among the record data in the processing unit 104, and an analysis result is output the outside through the input/output unit 105, and an image display thereof is performed. Therefore, the record data 104a and the setting data 8e may be transmitted in a wireless manner.

Accordingly, it is possible to provide the noise monitoring system capable of analyzing the source and the propagation path of the noise. Further, according to this configuration, since the error flag 109a and the vehicle data 109b can be obtained using a wireless LAN, the number of wirings and the wiring cost can be reduced.

## Claims

1. A noise monitoring system (101), comprising:
a detecting unit (103) configured to receive:
vehicle data (109b) indicating an operation state of a railway vehicle (10) and operation states of devices mounted on the railway vehicle;
an error flag (109a) indicating that a malfunction has occurred in one of the devices mounted on the railway vehicle; and
signals (102a) from a plurality of sensors(102), the plurality of sensors being configured to measure electromagnetic noises occurring in the devices mounted on the railway vehicle; wherein the detecting unit is further configured to associate the error flag with the signals input from the plurality of sensors;
a processing unit (104) configured to obtain a distribution of the electromagnetic noises occurring in the devices mounted on the railway vehicle on the basis of the error flag, the vehicle data, and the signals input from the plurality of sensors which are associated through the detecting unit; and
an output unit (105) configured to output information of the distribution of the electromagnetic noises occurring in the devices mounted on the railway vehicle which is obtained through the processing unit;
wherein the detecting unit includes:
a temporary storage memory (203) configured to temporarily store a plurality of signals (201a) in which the electromagnetic noises occurring in the devices mounted on the railway vehicle are detected, the plurality of signals being input from the plurality of sensors that measure the electromagnetic noises;
a recording control unit (206) configured to extract a plurality of signals (203a) corresponding to a predetermined period before and after a time at which the error flag is received from the plurality of signals in which the electromagnetic noises are detected, the plurality of signals being stored in the temporary storage memory; and
a storage unit (205) configured to store the plurality of signals corresponding to the predetermined period before and after the time at which the error flag is received, the plurality of signals being extracted through the recording control unit; and
wherein the processing unit includes:
a peak value detecting unit (401) configured to:
receive the signals from the plurality of sensors that measure the electromagnetic noises that correspond to the predetermined period before and after the time at which the error flag is received and are stored in the storage unit of the detecting unit; and detect peak values of waveforms of the signals of the plurality of sensors;
a phase detecting unit (402) configured to obtain time differences of times at which the peak values of the waveforms of the signals of the plurality of sensors are recorded; and
a noise distribution information analyzing unit (404) configured to obtain a distribution of the amplitudes of the electromagnetic noises using position information of the plurality of sensors that measure the electromagnetic noises, information of the peak values of the waveforms of the signal detected through the peak value detecting unit, and information of the time differences of the time at which the peak values of the waveforms detected through the peak value detecting unit are recorded

2. The noise monitoring system according to claim 1,
wherein the output unit is configured to visualize noise propagation states of the plurality of sensors arranged in the railway vehicle as the information of the distribution of the electromagnetic noise occurring in the devices mounted in the railway vehicle which is obtained through the processing unit, and output a visualization result.

3. A railway vehicle (10) equipped with a noise monitoring system (101), comprising:
a vehicle system control unit (111) configured to output vehicle data (109b) indicating an operation state and operation states of devices, and an error flag (109a) indicating that a malfunction has occurred in one of a plurality of mounted devices;
a sensor unit that includes a plurality of sensors (102), the plurality of sensors being configured to measure electromagnetic noises occurring in the mounted devices; and
a noise monitoring system (101) configured to:
receive the vehicle data and the error flag output from the vehicle system control unit and signals obtained by measuring the electromagnetic noises through the plurality of sensors of the sensor unit; and
obtain information of a distribution of the amplitudes of electromagnetic noises occurring in the devices;
wherein the noise monitoring system (101) includes:
a detecting unit (103) configured to associate the error flag output from the vehicle system control unit and the signals obtained by measuring the electromagnetic noises from the plurality of sensors of the sensor unit;
a processing unit (104) configured to obtain a distribution of the electromagnetic noises occurring in the devices mounted on the railway vehicle on the basis of the error flag, the vehicle data, and the signals input from the plurality of sensors which are associated through the detecting unit; and
an output unit (105) configured to output information of the distribution of the electromagnetic noises occurring in the devices mounted on the railway vehicle which is obtained through the processing unit;
wherein the detecting unit of the noise monitoring system includes:
a temporary storage memory (203) being configured to temporarily store a plurality of signals (201a) in which the electromagnetic noises occurring in the devices mounted on the railway vehicle are detected, the plurality of signals being input from a plurality of sensors that measure the electromagnetic noises;
a recording control unit (206) configured to extract a plurality of signals (203a) corresponding to a predetermined period before and after a time at which the error flag is received from the plurality of signals in which the electromagnetic noises are detected, the plurality of signals being stored in the temporary storage memory; and
a storage unit (205) configured to store the plurality of signals corresponding to the predetermined period before and after the time at which the error flag is received, the plurality of signals being extracted through the recording control unit; and
wherein the processing unit of the noise monitoring system includes:
a peak value detecting unit (401) configured to receive the signals from the plurality of sensors that measure the electromagnetic noises that correspond to the predetermined period before and after the time at which the error flag is received and are stored in the storage unit of the detecting unit; and detect peak values of waveforms of the signals of the plurality of sensors;
a phase detecting unit (402) configured to obtain time differences of times at which the peak values of the waveforms of the signals of the plurality of sensors are recorded; and
a noise distribution information analyzing unit (404) configured to obtain a distribution of the amplitudes of the electromagnetic noises using position information of the plurality of sensors that measure the electromagnetic noises, information of the peak values of the waveforms of the signal detected through the peak value detecting unit, and information of the time differences of the time at which the peak values of the waveforms detected through the peak value detecting unit are recorded.

4. The railway vehicle equipped with the noise monitoring system according to claim 3,
wherein the output unit of the noise monitoring system is configured to visualize noise propagation states of the plurality of sensors arranged in the railway vehicle as the information of the distribution of the electromagnetic noise occurring in the devices mounted in the railway vehicle which is obtained through the processing unit; and output a visualization result.

5. A noise monitoring method in a noise monitoring system (101), comprising:
receiving, by a detecting unit (103), vehicle data (109b) indicating an operation state of a railway vehicle (10) and operation states of devices mounted on the railway vehicle, an error flag (109a) indicating that a malfunction has occurred in one of the devices mounted on the railway vehicle, and signals (102a) from a plurality of sensors (102) that measure electromagnetic noises occurring in the devices mounted on the railway vehicle; and associating the error flag with the signals input from the plurality of sensors;
obtaining, by a processing unit (104), a distribution of the electromagnetic noises occurring in the devices mounted on the railway vehicle by processing the error flag, the vehicle data, and the signals input from the plurality of sensors which are associated; and
outputting, by an output unit (105), information of the obtained distribution of the amplitudes of the electromagnetic noises occurring in the devices mounted on the railway vehicle;
the noise monitoring method further including;
temporarily storing a plurality of signals (201a) in which the electromagnetic noises occurring in the devices mounted on the railway vehicle are detected in a temporary storage memory (203), the plurality of signals being input from the plurality of sensors that measure the electromagnetic noises,
extracting, by a recording control unit (206), a plurality of signals (203a) corresponding to a predetermined period before and after a time at which the error flag is received from the plurality of signals in which the electromagnetic noises are detected, the plurality of signals being stored in the temporary storage memory, and
storing the plurality of signals corresponding to the predetermined period before and after the time at which the error flag is received in a storage unit (205), the plurality of signals being extracted through the recording control unit;
wherein in the obtaining of the distribution of the amplitudes of the electromagnetic noise by the processing unit includes receiving, the signals of the plurality of sensors that measure the electromagnetic noises that correspond to the predetermined period before and after the time at which the error flag is received and are stored in the storage unit of the detecting unit and a peak value detecting unit (401) detects peak values of waveforms of the signals of the plurality of sensors,
wherein a phase detecting unit (402) obtains time differences of times at which the peak values of the waveforms of the signals of the plurality of sensors are recorded, and
wherein a noise distribution information analyzing unit (404) obtains a distribution of the amplitudes of the electromagnetic noises using position information of the plurality of sensors that measure the electromagnetic noises, information of the peak values of the waveforms of the signal detected through the peak value detecting unit, and information of the time differences of the time at which the peak values of the waveforms detected through the peak value detecting unit are recorded.

6. The noise monitoring method according to claim 5,
wherein the output unit visualizes noise propagation states of the plurality of sensors arranged in the railway vehicle as the information of the distribution of the electromagnetic noise occurring in the devices mounted in the railway vehicle which is obtained through the processing unit, and outputs a visualization result.

## Patentansprüche

1. Störungsüberwachungssystem (101), umfassend:
eine Detektionseinheit (103), die konfiguriert ist zum Empfangen von:
Fahrzeugdaten (109b), die einen Betriebszustand eines Schienenfahrzeugs (10) und Betriebszustände von Vorrichtungen, die an dem Schienenfahrzeug montiert sind, anzeigen;
einer Fehlerkennung (109a), die anzeigt, dass eine Fehlfunktion in einer der an dem Schienenfahrzeug montierten Vorrichtungen aufgetreten ist; und
Signalen (102a) von einer Vielzahl von Sensoren (102), wobei die Vielzahl von Sensoren konfiguriert ist, um in den an dem Schienenfahrzeug montierten Vorrichtungen auftretende elektromagnetische Störungen zu messen; wobei die Detektionseinheit konfiguriert ist, um die Fehlerkennung der Signaleingabe von der Vielzahl von Sensoren zuzuordnen;
eine Verarbeitungseinheit (104), die konfiguriert ist, um eine Verteilung der in den an dem Schienenfahrzeug montierten Vorrichtungen auftretenden elektromagnetischen Störungen zu erhalten, basierend auf der Fehlerkennung, den Fahrzeugdaten und der Signaleingabe von der Vielzahl von Sensoren, die durch die Detektionseinheit zugeordnet sind; und
eine Ausgabeeinheit (105), die konfiguriert ist, um Informationen über die Verteilung der in den an dem Schienenfahrzeug montierten Vorrichtungen auftretenden elektromagnetischen Störungen, die durch die Verarbeitungseinheit erhalten wird, auszugeben;
wobei die Detektionseinheit Folgendes umfasst:
einen temporären Speicher (203), der konfiguriert ist, um eine Vielzahl von Signalen (201a), in denen die in den auf dem Schienenfahrzeug montierten Vorrichtungen auftretenden elektromagnetischen Störungen detektiert werden, temporär zu speichern, wobei die Vielzahl von Signalen von der Vielzahl von Sensoren gegeben werden, welche die elektromagnetischen Störungen messen;
eine Aufzeichnungssteuereinheit (206), die konfiguriert ist, um eine Vielzahl von Signalen (203a) zu extrahieren, die einer vorbestimmten Zeitspanne vor und nach einer Zeit, zu der die Fehlerkennung von der Vielzahl an Signalen, in denen die elektromagnetischen Störungen detektiert werden, entsprechen, wobei die Vielzahl von Signalen in dem temporären Speicher gespeichert wird; und
eine Speichereinheit (205), die konfiguriert ist, um die Vielzahl von Signalen zu speichern, die der vorbestimmten Zeitspanne vor und nach der Zeit, zu der die Fehlerkennung erhalten wird, entsprechen, wobei die Vielzahl von Signalen durch die Aufzeichnungssteuereinheit extrahiert wird; und
wobei die Verarbeitungseinheit Folgendes umfasst:
eine Spitzenwertdetektionseinheit (401), die konfiguriert ist, um:
die Signale von der Vielzahl von Sensoren zu empfangen, welche die elektromagnetischen Störungen messen, die der vorbestimmten Zeitspanne vor und nach der Zeit, zu der die Fehlerkennung erhalten wird, entsprechen, und in der Speichereinheit der Detektionseinheit gespeichert werden; und um Spitzenwerte von Wellenformen der Signale der Vielzahl von Sensoren zu detektieren;
eine Phasendetektionseinheit (402), die konfiguriert ist, um Zeitdifferenzen von Zeiten, zu denen die Spitzenwerte der Wellenformen der Signale der Vielzahl von Sensoren aufgezeichnet werden, zu erhalten; und
eine Störungsverteilungs-Informations-Analyseeinheit (404), die konfiguriert ist, um eine Verteilung der Amplituden der elektromagnetischen Störungen zu erhalten, unter Verwendung von Positionsinformationen der Vielzahl von Sensoren, welche die elektromagnetischen Störungen messen, Informationen über die Spitzenwerte der Wellenformen des durch die Spitzenwertdetektionseinheit detektierten Signals und Informationen über die Zeitdifferenzen der Zeit, zu der die Spitzenwerte der Wellenformen, die durch die Spitzenwertdetektionseinheit detektiert werden, aufgezeichnet werden.

2. Störungsüberwachungssystem nach Anspruch 1,
wobei die Ausgabeeinheit konfiguriert ist, um die Zustände der Störungsausbreitung der Vielzahl von Sensoren, die in dem Schienenfahrzeug angeordnet sind, als Informationen der Verteilung der in den auf dem Schienenfahrzeug montierten Vorrichtungen auftretenden Störungen, die durch die Verarbeitungseinheit erhalten werden, sichtbar zu machen und ein Ergebnis der Sichtbarmachung auszugeben.

3. Schienenfahrzeug (10), ausgestattet mit einem Störungsüberwachungssystem (101), umfassend:
eine Fahrzeugsystem-Steuereinheit (111), die konfiguriert ist, um Fahrzeugdaten (109b) auszugeben, die einen Betriebszustand und Betriebszustände von Vorrichtungen und eine Fehlerkennung (109a), die anzeigt, dass eine Fehlfunktion in einer von einer Vielzahl von montierten Vorrichtungen aufgetreten ist, anzeigen;
eine Sensoreinheit, die eine Vielzahl von Sensoren (102) umfasst, wobei die Vielzahl von Sensoren konfiguriert ist, um elektromagnetische Störungen zu messen, die in den montierten Vorrichtungen auftreten; und
ein Störungsüberwachungssystem (101), das konfiguriert ist, um:
die Fahrzeugdaten und die Fehlerkennungs-Ausgabe von der Fahrzeugsystem-Steuereinheit und von Signalen, die durch das Messen der elektromagnetischen Störungen durch die Vielzahl von Sensoren der Sensoreinheit erhalten wurden, zu erhalten; und
um Informationen über eine Verteilung der Amplituden der in den Vorrichtungen auftretenden elektromagnetischen Störungen zu erhalten;
wobei das Störungsüberwachungssystem (101) Folgendes umfasst:
eine Detektionseinheit (103), die konfiguriert ist, um die Fehlerkennungs-Ausgabe der Fahrzeugsystem-Steuereinheit und die Signale, die durch das Messen der elektromagnetischen Störungen von der Vielzahl von Sensoren der Sensoreinheit erhalten wurden, zuzuordnen;
eine Verarbeitungseinheit (104), die konfiguriert ist, um eine Verteilung der in den auf dem Schienenfahrzeug montierten Vorrichtungen auftretenden elektromagnetischen Störungen zu erhalten, auf der Basis der Fehlerkennung, der Fahrzeugdaten und der Signaleingabe von der Vielzahl von Sensoren, die durch die Detektionseinheit zugeordnet sind; und
eine Ausgabeeinheit (105), die konfiguriert ist, um Informationen über die Verteilung der elektromagnetischen Störungen, die in den Vorrichtungen, die auf dem Schienenfahrzeug montiert sind, auftreten, die durch die Verarbeitungseinheit erhalten werden, auszugeben;
wobei die Detektionseinheit des Störungsüberwachungssystems Folgendes umfasst:
einen temporären Speicher (203), der konfiguriert ist, um eine Vielzahl von Signalen (201a) zu speichern, in denen die elektromagnetischen Störungen, die in den auf dem Schienenfahrzeug montierten Vorrichtungen auftreten, detektiert werden, wobei die Vielzahl von Signalen in dem temporären Speicher gespeichert werden;
eine Aufzeichnungssteuereinheit (206), die konfiguriert ist, um eine Vielzahl von Signalen (203a) zu extrahieren, die einer vorbestimmten Zeitspanne vor und nach einer Zeit, zu der die Fehlerkennung von der Vielzahl von Signalen erhalten wurde, in denen die elektromagnetischen Störungen detektiert werden, entsprechen, wobei die Vielzahl von Signalen in dem temporären Speicher gespeichert werden; und
eine Speichereinheit (205), die konfiguriert ist, um die Vielzahl von Signalen zu speichern, die der vorbestimmten Zeitspanne vor und nach den Zeiten, zu denen die Fehlerkennung erhalten wird, entsprechen, wobei die Vielzahl von Signalen durch die Aufzeichnungssteuereinheit extrahiert wird; und
wobei die Verarbeitungseinheit des Störungsüberwachungssystems Folgendes umfasst:
eine Spitzenwertdetektionseinheit (401), die konfiguriert ist, um die Signale von der Vielzahl von Sensoren zu erhalten, welche die elektromagnetischen Störungen messen, die der vorbestimmten Zeitspanne vor und nach der Zeit, zu dem die Fehlerkennung erhalten wird, entsprechen, und die in der Speichereinheit der Detektionseinheit gespeichert werden; und um Spitzenwerte von Wellenformen der Signale der Vielzahl von Sensoren zu detektieren;
eine Phasen-Detektionseinheit (402), die konfiguriert ist, um Zeitdifferenzen von Zeiten zu erhalten, zu denen die Spitzenwerte der Wellenformen der Signale der Vielzahl von Sensoren aufgezeichnet werden; und
eine Störungsverteilungs-Informations-Analyseeinheit (404), die konfiguriert ist, um eine Verteilung der Amplituden der elektromagnetischen Störungen zu erhalten, unter Verwendung von Positionsinformationen der Vielzahl von Sensoren, welche die elektromagnetischen Störungen messen, Informationen über die Spitzenwerte der Wellenformen des Signals, das durch die Spitzenwertdetektionseinheit detektiert wird und Informationen über die Zeitdifferenzen der Zeit, zu der die durch die Spitzenwertdetektionseinheit detektierten Spitzenwerte aufgezeichnet werden.

4. Schienenfahrzeug, ausgestattet mit dem Störungsüberwachungssystem nach Anspruch 3,
wobei die Ausgabeeinheit des Störungsüberwachungssystems konfiguriert ist, um die Zustände der Störungsausbreitung der Vielzahl von Sensoren, die in dem Schienenfahrzeug angeordnet sind, als Informationen der Verteilung der in den auf dem Schienenfahrzeug montierten Vorrichtungen auftretenden Störungen, die durch die Verarbeitungseinheit erhalten werden, sichtbar zu machen; und um ein Ergebnis der Sichtbarmachung auszugeben.

5. Störungsüberwachungsverfahren in einem Störungsüberwachungssystem (101), umfassend:
Empfangen von Fahrzeugdaten (109b), die einen Betriebszustand eines Schienenfahrzeugs (10) und Betriebszustände von auf dem Schienenfahrzeug montierten Vorrichtungen, eine Fehlerkennung (109a), die anzeigt, dass eine Fehlfunktion in einer der auf dem Schienenfahrzeug montierten Vorrichtungen aufgetreten ist und Signale (102a) von einer Vielzahl von Sensoren (102), welche die elektromagnetischen Störungen messen, die in den auf dem Schienenfahrzeug montierten Vorrichtungen auftreten, durch eine Detektionseinheit (103); und Zuordnen der Fehlerkennung mit der Signaleingabe der Vielzahl von Sensoren;
Erhalten einer Verteilung den elektromagnetischen Störungen, die in den auf dem Schienenfahrzeug montierten Vorrichtungen auftreten, durch das Verarbeitung der Fehlerkennung, der Fahrzeugdaten und der Signaleingabe von der Vielzahl von Sensoren, die zugeordnet sind, durch eine Verarbeitungseinheit (104); und
Ausgeben von Informationen über die erhaltene Verteilung der Amplituden der elektromagnetischen Störungen, die in den auf dem Schienenfahrzeug montierten Vorrichtungen auftreten, durch eine Ausgabeeinheit (105); wobei das Störungsüberwachungsverfahren weiters umfasst:
temporäres Speichern einer Vielzahl von Signalen (201a), in denen die elektromagnetischen Störungen, die in den auf dem Schienenfahrzeug montierten Vorrichtungen auftreten, in einem temporären Speicher (203) detektiert werden, wobei die Vielzahl von Signalen von der Vielzahl von Sensoren, welche die elektromagnetischen Störungen messen, eingegeben wird,
Extrahieren einer Vielzahl von Signalen (203a) durch eine Aufzeichnungssteuereinheit (206), die einer vorbestimmten Zeitspanne vor und nach einem Zeitpunkt, zu dem die Fehlerkennung von der Vielzahl von Signalen, in denen die elektromagnetischen Störungen detektiert werden, empfangen wird, entsprechen, wobei die Vielzahl von Signalen in dem temporären Speicher gespeichert wird, und
Speichern der Vielzahl von Signalen, die der vorbestimmten Zeitspanne vor und nach der Zeit, zu der die Fehlerkennung in einer Speichereinheit (205) empfangen wird, entsprechen, wobei die Vielzahl von Signalen durch die Aufzeichnungssteuereinheit extrahiert wird;
wobei beim Erhalten der Verteilung der Amplituden der elektromagnetischen Störungen durch die Verarbeitungseinheit das Empfangen der Signale der Vielzahl von Sensoren umfasst ist, welche die elektromagnetischen Störungen messen, die der vorbestimmten Zeitspanne entsprechen, zu dem die Fehlerkennung empfangen wird und sie in der Speichereinheit der Detektionseinheit gespeichert werden und eine Spitzenwertdetektionseinheit (401) Spitzenwerte von Wellenformen der Signale der Vielzahl von Sensoren detektiert,
wobei eine Phasendetektionseinheit (402) Zeitdifferenzen von Zeiten erhält, zu denen die Spitzenwerte der Wellenformen der Signale der Vielzahl von Sensoren aufgezeichnet werden, und
wobei eine Störungsverteilungs-Informations-Analyseeinheit (404) eine Verteilung der Amplituden der elektromagnetischen Störungen erhält, unter Verwendung von Positionsinformationen der Vielzahl von Sensoren, welche die elektromagnetischen Störungen messen, Informationen über die Spitzenwerte der Wellenformen des durch die Spitzenwertdetektionseinheit detektierten Signals und Informationen über die Zeitdifferenzen der Zeit, zu der die Spitzenwerte der Wellenformen, die durch die Spitzenwertdetektionseinheit detektiert werden, aufgezeichnet werden.

6. Störungsüberwachungsverfahren nach Anspruch 5,
wobei die Ausgabeeinheit die Zustände der Störungsausbreitung der Vielzahl von Sensoren, die in dem Schienenfahrzeug angeordnet sind, als Informationen der Verteilung der in den auf dem Schienenfahrzeug montierten Vorrichtungen auftretenden Störungen, die durch die Verarbeitungseinheit erhalten werden, sichtbar macht und ein Ergebnis der Sichtbarmachung ausgibt.

## Revendications

1. Système de surveillance de bruit (101), comprenant :
une unité de détection (103) configurée de manière à recevoir :
des données de véhicule (109b) indiquant un état de fonctionnement d'un véhicule ferroviaire (10) et des états de fonctionnement de dispositifs montés sur le véhicule ferroviaire ;
un drapeau d'erreur (109a) indiquant qu'un dysfonctionnement a été rencontré dans l'un des dispositifs montés sur le véhicule ferroviaire ; et
des signaux (102a) provenant d'une pluralité de capteurs (102), la pluralité de capteurs étant configurée de manière à mesurer des bruits électromagnétiques rencontrés dans les dispositifs montés sur le véhicule ferroviaire ; dans lequel l'unité de détection est en outre configurée de manière à associer le drapeau d'erreur aux signaux appliqués en entrée à partir de la pluralité de capteurs ;
une unité de traitement (104) configurée de manière à obtenir une distribution des bruits électromagnétiques rencontrés dans les dispositifs montés sur le véhicule ferroviaire, sur la base du drapeau d'erreur, des données de véhicule et des signaux appliqués en entrée à partir de la pluralité de capteurs, qui sont associés par l'intermédiaire de l'unité de détection ; et
une unité de sortie (105) configurée de manière à fournir en sortie des informations de la distribution des bruits électromagnétiques rencontrés dans les dispositifs montés sur le véhicule ferroviaire, laquelle est obtenue par l'unité de traitement ;
dans lequel l'unité de détection inclut :
une mémoire de stockage temporaire (203) configurée de manière à stocker temporairement une pluralité de signaux (201a) dans laquelle les bruits électromagnétiques rencontrés dans les dispositifs montés sur le véhicule ferroviaire sont détectés, la pluralité de signaux étant appliquée en entrée à partir de la pluralité de capteurs mesurant les bruits électromagnétiques ;
une unité de commande d'enregistrement (206) configurée de manière à extraire une pluralité de signaux (203a) correspondant à une période prédéterminée avant et après un instant auquel le drapeau d'erreur est reçu en provenance de la pluralité de signaux dans laquelle les bruits électromagnétiques sont détectés, la pluralité de signaux étant stockée dans la mémoire de stockage temporaire ; et
une unité de stockage (205) configurée de manière à stocker la pluralité de signaux correspondant à la période prédéterminée avant et après l'instant auquel le drapeau d'erreur est reçu, la pluralité de signaux étant extraite par le biais de l'unité de commande d'enregistrement ; et
dans lequel l'unité de traitement comprend :
une unité de détection de valeurs de crête (401) configurée de manière à :
recevoir les signaux en provenance de la pluralité de capteurs qui mesure les bruits électromagnétiques qui correspondent à la période prédéterminée avant et après l'instant auquel le drapeau d'erreur est reçu, et qui sont stockés dans l'unité de stockage de l'unité de détection ; et détecter des valeurs de crête des formes d'onde des signaux de la pluralité de capteurs ;
une unité de détection de phase (402) configurée de manière à obtenir des différences temporelles d'instants auxquels les valeurs de crête des formes d'onde des signaux de la pluralité de capteurs sont enregistrées ; et
une unité d'analyse d'informations de distribution de bruit (404) configurée de manière à obtenir une distribution des amplitudes des bruits électromagnétiques en utilisant des informations de position de la pluralité de capteurs qui mesure les bruits électromagnétiques, des informations des valeurs de crête des formes d'onde du signal détectées par l'unité de détection de valeurs de crête, et des informations des différences temporelles de l'instant auquel les valeurs de crête des formes d'onde détectées par le biais de l'unité de détection de valeurs de crête sont enregistrées.

2. Système de surveillance de bruit selon la revendication 1,
dans lequel l'unité de sortie est configurée de manière à visualiser les états de propagation du bruit de la pluralité de capteurs agencée dans le véhicule ferroviaire, en tant que les informations de la distribution du bruit électromagnétique rencontré dans les dispositifs montés dans le véhicule ferroviaire, laquelle est obtenue par le biais de l'unité de traitement, et à fournir en sortie un résultat de visualisation.

3. Véhicule ferroviaire (10) équipé d'un système de surveillance de bruit (101), comprenant :
une unité de commande de système de véhicule (111) configurée de manière à fournir en sortie des données de véhicule (109b) indiquant un état de fonctionnement, et des états de fonctionnement de dispositifs, et un drapeau d'erreur (109a) indiquant qu'un dysfonctionnement a été rencontré dans un dispositif parmi une pluralité de dispositifs montés ;
une unité de capteur qui inclut une pluralité de capteurs (102), la pluralité de capteurs étant configurée de manière à mesurer des bruits électromagnétiques rencontrés dans les dispositifs montés ; et
un système de surveillance de bruit (101) configuré de manière à :
recevoir les données de véhicule et le drapeau d'erreur fournis en sortie à partir de l'unité de commande de système de véhicule, et des signaux obtenus en mesurant les bruits électromagnétiques à travers la pluralité de capteurs de l'unité de capteur ; et
obtenir des informations d'une distribution des amplitudes des bruits électromagnétiques rencontrés dans les dispositifs ;
dans lequel le système de surveillance de bruit (101) inclut :
une unité de détection (103) configurée de manière à associer le drapeau d'erreur fourni en sortie à partir de l'unité de commande de système de véhicule et les signaux obtenus en mesurant les bruits électromagnétiques provenant de la pluralité de capteurs de l'unité de détection ;
une unité de traitement (104) configurée de manière à obtenir une distribution des bruits électromagnétiques rencontrés dans les dispositifs montés sur le véhicule ferroviaire sur la base du drapeau d'erreur, des données de véhicule et des signaux appliqués en entrée à partir de la pluralité de capteurs qui sont associés par l'intermédiaire de l'unité de détection ; et
une unité de sortie (105) configurée de manière à fournir en sortie des informations de la distribution des bruits électromagnétiques rencontrés dans les dispositifs montés sur le véhicule ferroviaire, laquelle est obtenue par l'unité de traitement ;
dans lequel l'unité de détection du système de surveillance de bruit inclut :
une mémoire de stockage temporaire (203) configurée de manière à stocker temporairement une pluralité de signaux (201a) dans laquelle les bruits électromagnétiques rencontrés dans les dispositifs montés sur le véhicule ferroviaire sont détectés, la pluralité de signaux étant appliquée en entrée à partir de la pluralité de capteurs qui mesure les bruits électromagnétiques ;
une unité de commande d'enregistrement (206) configurée de manière à extraire une pluralité de signaux (203a) correspondant à une période prédéterminée avant et après un instant auquel le drapeau d'erreur est reçu en provenance de la pluralité de signaux dans laquelle les bruits électromagnétiques sont détectés, la pluralité de signaux étant stockée dans la mémoire de stockage temporaire ; et
une unité de stockage (205) configurée de manière à stocker la pluralité de signaux correspondant à la période prédéterminée avant et après l'instant auquel le drapeau d'erreur est reçu, la pluralité de signaux étant extraite par le biais de l'unité de commande d'enregistrement ; et
dans lequel l'unité de traitement système de surveillance de bruit inclut :
une unité de détection de valeurs de crête (401) configurée de manière à recevoir les signaux en provenance de la pluralité de capteurs qui mesure les bruits électromagnétiques qui correspondent à la période prédéterminée avant et après l'instant auquel le drapeau d'erreur est reçu, et qui sont stockés dans l'unité de stockage de l'unité de détection, et à détecter des valeurs de crête des formes d'onde des signaux de la pluralité de capteurs ;
une unité de détection de phase (402) configurée de manière à obtenir des différences temporelles d'instants auxquels les valeurs de crête des formes d'onde des signaux de la pluralité de capteurs sont enregistrées ; et
une unité d'analyse d'informations de distribution de bruit (404) configurée de manière à obtenir une distribution des amplitudes des bruits électromagnétiques en utilisant des informations de position de la pluralité de capteurs qui mesure les bruits électromagnétiques, des informations des valeurs de crête des formes d'onde du signal détectées par l'unité de détection de valeurs de crête, et des informations des différences temporelles de l'instant auquel les valeurs de crête des formes d'onde détectées par le biais de l'unité de détection de valeurs de crête sont enregistrées.

4. Véhicule ferroviaire équipé du système de surveillance de bruit selon la revendication 3,
dans lequel l'unité de sortie du système de surveillance de bruit est configurée de manière à visualiser des états de propagation du bruit de la pluralité de capteurs agencée dans le véhicule ferroviaire, en tant que les informations de la distribution du bruit électromagnétique rencontré dans les dispositifs montés dans le véhicule ferroviaire, laquelle est obtenue par le biais de l'unité de traitement, et à fournir en sortie un résultat de visualisation.

5. Procédé de surveillance de bruit dans un système de surveillance de bruit (101), comprenant les étapes ci-dessous consistant à :
recevoir, par le biais d'une unité de détection (103), des données de véhicule (109b) indiquant un état de fonctionnement d'un véhicule ferroviaire (10) et des états de fonctionnement de dispositifs montés sur le véhicule ferroviaire, un drapeau d'erreur (109a) indiquant qu'un dysfonctionnement a été rencontré dans l'un des dispositifs montés sur le véhicule ferroviaire, et des signaux (102a) provenant d'une pluralité de capteurs (102) qui mesure les bruits électromagnétiques rencontrés dans les dispositifs montés sur le véhicule ferroviaire ; et associer le drapeau d'erreur aux signaux appliqués en entrée à partir de la pluralité de capteurs ;
obtenir, par le biais d'une unité de traitement (104), une distribution des bruits électromagnétiques rencontrés dans les dispositifs montés sur le véhicule ferroviaire en traitant le drapeau d'erreur, les données de véhicule et les signaux appliqués en entrée à partir de la pluralité de capteurs qui sont associés ; et
fournir en sortie, par le biais d'une unité de sortie (105), des informations de la distribution obtenue des amplitudes des bruits électromagnétiques rencontrés dans les dispositifs montés sur le véhicule ferroviaire ;
le procédé de surveillance de bruit comprenant en outre les étapes ci-dessous consistant à :
stocker temporairement une pluralité de signaux (201a) dans laquelle les bruits électromagnétiques rencontrés dans les dispositifs montés sur le véhicule ferroviaire sont détectés dans une mémoire de stockage temporaire (203), la pluralité de signaux étant appliquée en entrée à partir de la pluralité de capteurs qui mesure les bruits électromagnétiques ;
extraire, par le biais d'une unité de commande d'enregistrement (206), une pluralité de signaux (203a) correspondant à une période prédéterminée avant et après un instant auquel le drapeau d'erreur est reçu en provenance de la pluralité de signaux dans laquelle les bruits électromagnétiques sont détectés, la pluralité de signaux étant stockée dans la mémoire de stockage temporaire ; et
stocker la pluralité de signaux correspondant à la période prédéterminée avant et après l'instant auquel le drapeau d'erreur est reçu dans une unité de stockage (205), la pluralité de signaux étant extraite par le biais de l'unité de commande d'enregistrement ;
dans lequel, l'étape d'obtention de la distribution des amplitudes du bruit électromagnétique par l'unité de traitement inclut l'étape consistant à recevoir les signaux de la pluralité de capteurs qui mesure les bruits électromagnétiques qui correspondent à la période prédéterminée avant et après l'instant auquel le drapeau d'erreur est reçu et qui sont stockés dans l'unité de stockage de l'unité de détection, et dans lequel une unité de détection de valeurs de crête (401) détecte des valeurs de crête de formes d'onde des signaux de la pluralité de capteurs ;
dans lequel une unité de détection de phase (402) obtient des différences temporelles d'instants auxquels les valeurs de crête des formes d'onde des signaux de la pluralité de capteurs sont enregistrées ; et
dans lequel une unité d'analyse d'informations de distribution de bruit (404) obtient une distribution des amplitudes des bruits électromagnétiques, en utilisant des informations de position de la pluralité de capteurs qui mesure les bruits électromagnétiques, des informations des valeurs de crête des formes d'onde du signal détectées par le biais de l'unité de détection de valeurs de crête, et des informations des différences temporelles de l'instant auquel les valeurs de crête des formes d'onde détectées par l'unité de détection de valeurs de crête sont enregistrées.

6. Procédé de surveillance de bruit selon la revendication 5,
dans lequel l'unité de sortie visualise des états de propagation du bruit de la pluralité de capteurs agencée dans le véhicule ferroviaire, en tant que les informations de la distribution du bruit électromagnétique rencontré dans les dispositifs montés dans le véhicule ferroviaire, laquelle est obtenue par le biais de l'unité de traitement, et fournit en sortie un résultat de visualisation.
